Europäisches Patentamt

European Patent Office

Office européen des brevets

(19)

(11) Publication number: **0 191 671**
**B1**

(12) **EUROPEAN PATENT SPECIFICATION**

(45) Date of publication of patent specification: **21.09.88**

(51) Int. Cl.⁴: **C 30 B 33/00,** C 30 B 15/00, C 30 B 29/30

(21) Application number: **86400118.5**

(22) Date of filing: **21.01.86**

(54) **A method for the poling treatment of a lithium tantalate single crystal.**

(30) Priority: **22.01.85 JP 9509/85**

(43) Date of publication of application:
**20.08.86 Bulletin 86/34**

(45) Publication of the grant of the patent:
**21.09.88 Bulletin 88/38**

(84) Designated Contracting States:
**DE FR GB**

(56) References cited:
**SOLID STATE TECHNOLOGY, vol. 17, no. 1,
January 1974, pages 52-55; D.W. RUDD et al.:
"Growth of lithium tantalate crystals for
transmission resonator and filter devices"**

(73) Proprietor: **Shin-Etsu Chemical Co., Ltd.
6-1, Ohtemachi 2-chome
Chiyoda-ku Tokyo 100 (JP)**

(72) Inventor: **Watanabe, Masataka
999-1, Oaza Sueno Sanwa-mura
Nakakubiki-gun Niigata-ken (JP)**
Inventor: **Masaaki, Iguchi
c/o A-8, Goubara Apartment, 165-1, Goubara
Annaka-shi Gunma-ken (JP)**

(74) Representative: **Armengaud Ainé, Alain et al
Cabinet ARMENGAUD AINE 3 Avenue Bugeaud
F-75116 Paris (FR)**

Courier Press, Leamington Spa, England.

## Description

### Background of the invention

The present invention relates to a method for the poling treatment of a single crystal of lithium tantalate to convert the same into a single ferroelectric domain. More particularly, the invention relates to a method for the poling treatment of a single crystal of lithium tantalate in which very high uniformity is ensured in the conversion of the single crystal boule or rod into a single ferroelectric domain which otherwise is non-uniform due to the gravity on the single crystal boule per se.

As a useful ferroelectric material, single crystal boules of lithium tantalate as grown are usually subjected to a poling treatment so as to convert the whole boule of the single crystal into a single ferroelectric domain prior to further processing works. The method of the poling treatment is well known in the art, (see e.g. D. W. Budd, Solid State Technology, Vol. 17, No. 1, January 1974, pages 52—55), in which the single crystal boule as grown by the Czochralski method is sandwiched side by side with two symmetrical electrodes along the axial direction of the boule and a direct-current voltage is applied between the electrodes so that the single crystal boule is placed in a uniform electric field perpendicular to the axis of the boule.

As a general trend in the technology of single crystal growing toward larger and larger diameters of the single crystal boules grown by the Czochralski method with an object to improve the productivity, single crystal boules of lithium tantalate produced in recent years have a diameter increasing year by year to reach 12,7 cm (5 inches) or larger. A single crystal boule of such a large diameter naturally has a great weight so that the piezoelectric effect by the body weight of the single crystal is no longer negligible within the single crystal boule. The piezoelectrically induced polarization of the single crystal, as a matter of course, disturbs the uniform distribution of the externally applied electric field in which the single crystal boule is placed when it is subjected to a poling treatment. As a problem newly brought about, accordingly, it is not an easy matter to ensure high uniformity in the effect of the poling treatment when the single crystal boule of lithium tantalate has such large dimensions.

When a single crystal boule of lithium tantalate grown in the direction of the x-axis is held horizontally with the z-axis in parallel to the vertical direction and the electric field for the poling treatment is impressed in parallel to the z-axis by sandwiching the boule with two side-by-side electrodes on the upside and downside of the boule, for example, the electric field cannot be uniform, in particular, in the lower portion of the horizontally held single crystal boule where the externally applied electric field is partly offset by the piezoelectric effect in the reverse direction of the z-axis caused by the gravity of which the compressive stress is larger in the lower portion where the single crystal is sometimes left unpoled.

### Summary of the invention

An object of the present invention therefore is to provide a method for the poling treatment of a single crystal boule of lithium tantalate to convert the single crystal into a single ferroelectric domain, in which very high uniformity of the poling effect can be obtained by eliminating the adverse influence of the piezoelectric effect due to the gravity of the single crystal boule per se.

Another object of the invention is to provide an improvement in the method for the poling treatment of a single crystal of lithium tantalate, in which high uniformity of the poling effect can be obtained even by the impression of a relatively low voltage between the electrodes sandwiching the single crystal body.

Thus, the improvement provided by the invention comprises, a method for the poling treatment of a single crystal boule of lithium tantalate as grown in the crystallographic x-axis to convert the single crystal body into a single ferroelectric domain by the application of an electric field in the direction of the crystallographic z-axis, characterized in applying a compressive force to the single crystal boule in the substantially vertical direction during the application of the electric field.

In particular, it is preferable that the single crystal body during the poling treatment is held with the z-axis in a substantially horizontal direction so that the polarization caused by the piezoelectric effect under the compressive force is in the same direction as the z-axis. In this case, the electric field is applied of course in a horizontal direction.

Further, the compressive force applied in the vertical direction should preferably be so large to be in the range from 20% to 400% of the weight of the single crystal boule.

### Brief description of the drawing

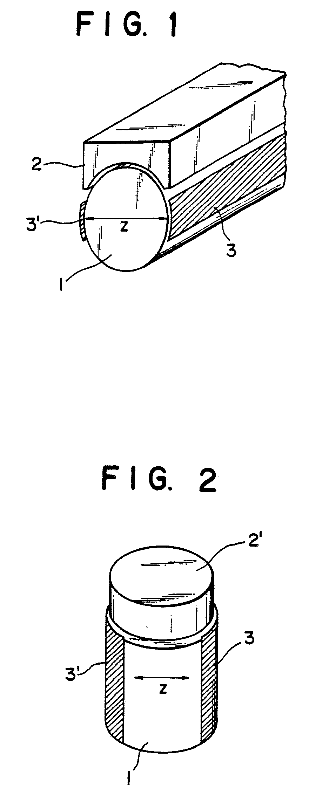

Figures 1 and 2 each illustrate a partial perspective view of a single crystal of lithium tantalate under the poling treatment according to the method of the invention. The single crystal boule is held with the x-axis in a horizontal direction or in the vertical direction in Figure 1 and in Figure 2, respectively.

### Detailed description of the preferred embodiments

In the following, the method of the invention is described in detail with reference to the accompanying drawing.

In Figure 1, the single crystal boule 1 of lithium tantalate, of which the crystallographic x-axis coincides with the axial direction of the boule, is held in such a disposition that the x-axis lies in a substantially horizontal direction. It is preferable that the crystallographic z-axis, which is of course perpendicular to the x-axis, lies also in a horizontal direction. A compressive force in the vertical direction, i.e. the direction of gravity, is applied to the single crystal boule 1 by putting a weighting body 2 on the boule 1. The weighting body 2 should be made of an electrically insulating material and should extend over the whole length of the single crystal boule 1. A pair of electrodes 3, 3' also extending over whole length of the single crystal boule 1 sandwich the boule 1 at both ends of a diameter in the direction of the z-axis.

In this arrangement, the whole body of the single crystal boule 1 is under the compressive force in the vertical direction given by the weighting body 2 thereon correspondingly producing a piezoelectric effect. The direction of the polarization caused by the piezoelectric effect coincides with the z-axis. Accordingly, the uniformity of the disturbing influence by the piezoelectric effect on the externally applied poling electric field can be increased so much throughout the single crystal boule when a voltage is impressed between the electrodes 3, 3' so that high uniformity of the electric field is obtained with a negligibly small difference in the strength of the electric field between the upper and lower portions of the single crystal boule 1 to ensure complete conversion of the single crystal into a single domain.

The electrically insulating material of the weighting body 2 to put on the single crystal boule 1 is not particularly limitative. For example, shaped bodies of various kinds of ceramics such as alumina and zirconia can be used satisfactorily. The weighting body 2 can be made of course of the same crystalline material as the single crystal boule 1 per se. The compressive force applied to the single crystal boule 1 in the vertical direction can be controlled by suitably selecting the weight of the weighting body 2. When the weight 2 is too small to give a sufficient compressive force to the single crystal boule 1, it is optional that an additional external force is applied to supplement the weight of the weighting body 2. At any rate, the compressive force should be so large as to be in the range from 20% to 400% or, preferably, from 50% to 200% of the weight of the single crystal boule 1. When the compressive force is smaller than the above mentioned lower limit, the effect of compression is insufficient as a matter of course so that the desired uniformity of the electric field cannot be obtained in the poling treatment. When the compressive force is too large, on the other hand, the single crystal rod 1 may be destroyed.

Figure 2 illustrates another preferable embodiment of the inventive method by a partial perspective view of a single crystal boule 1 of lithium tantalate held upright with the crystallographic x-axis in the substantially vertical direction. In this case, the weighting body 2' is put on the upper end surface of the single crystal boule 1 so that the compressive force is applied to the boule 1 throughout from the upper end to the lower. The electrodes 3, 3' are disposed laterally on both sides of the boule 1 at the opposite ends of the z-axis. In this arrangement, the polarization by the piezoelectric effect appears also in the upper portion of the single crystal boule 1 in the direction of the z-axis. When an electric voltage is impressed between the electrodes 3, 3', accordingly, the difference in the strength of the electric field is minimized between the upper and lower portions of the single crystal boule 1 due to the uniformized influence of the piezoelectric effect so that high uniformity is obtained in the conversion of the single crystal into a single domain.

Following is an example to illustrate the method of the present invention in more detail.

Example

A single crystal boule of lithoum tantalate having a diameter of 10,16 cm (4 inches) and a length of about 100 mm was grown by the Czochralski method by pulling up in the direction of the x-axis. The single crystal boule was held with the x- and z-axes in horizontal directions and a weighting body having a weight of up to 5 times of the single crystal boule was put thereon as is illustrated in Figure 1 with a pair of electrodes oppositely sandwiching the single crystal boule. When the temperature was increased and had reached 630°C, a DC voltage of 30 volts was imposed between the electrodes to perform the poling treatment.

The single crystal boule after the poling treatment in this manner was examined for the completeness of conversion into a single domain by the stress test using polarized light and by the light diffraction test using a helium-neon laser to give the results shown in Table 1 below by three ratings of A, B and C for complete poling throughout the whole body of the single crystal boule, poling over about 90% of the single crystal boule, and poor poling over whole body of the boule, respectively.

TABLE 1

| Weight of load, % of the body weight of boule | Completeness of poling |
|---|---|
| (None) | C |
| 20 | B |
| 50 | A |
| 100 | A |
| 200 | A |
| 400 | B |
| 500 | C |

**Claims**

1. A method for the poling treatment of a single crystal boule of lithium tantalate as grown in the crystallographic x-axis to convert the single crystal boule into a single ferroelectric domain by the application of an electric field in the direction of the crystallographie z-axis, characterized in applying a compressive force to the single crystal boule in a substantially vertical direction during the application of the electric field.

2. The improvement as claimed in claim 1 wherein the single crystal boule is held in such a disposition that the z-axis is in a substantially horizontal direction.

3. The improvement as claimed in claim 1 wherein the compressive force is so large as to be in the range from 20% to 400% of the weight of the single crystal boule.

**Patentansprüche**

1. Verfahren zum Polarisieren eines in der kristallografischen x-Achse gezogenen Lithiumtantalat-Einkristallzylinders, wobei der Zylinder in einen Eindomänenkristall durch Anlegen eines elektrischen Feldes in Richtung der kristallografischen z-Achse umgewandelt wird, dadurch gekennzeichnet, daß der Einkristallzylinder während der Einwirkung des elektrischen Feldes mit einer zum Feld senkrecht orientierten Druckkraft beaufschlagt wird.

2. Verfahren nach Anspruch 1, wobei der Einkristallzylinder derart gelagert ist, daß die z-Achse annähernd horizontal ausgerichtet ist.

3. Verfahren nach Anspruch 1, wobei die Druckkraft im Bereich zwischen 20% und 400% des Gewichts des Einkristallzylinders liegt.

**Revendications**

1. Procédé de polarisation d'une boule de monocristal de tantalate de lithium issue d'une croissance selon l'axe cristallographique x, de manière à transformer la boule de monocristal en un domaine ferroélectrique par application d'un champ électrique dans la direction de l'axe cristallographique z, caractérisé en ce qu'on applique une force de compression à la boule de monocristal dans une direction sensiblement verticale lors de l'application du champ électrique.

2. Procédé selon la revendication 1 dans lequel la boule de monocristal est maintenue dans une disposition telle que l'axe z est une direction sensiblement horizontale.

3. Procédé selon la revendication 1, dans lequel la force de compression est suffisamment importante pour être comprise entre 20% et 400% du poids de la boule de monocristal.

# F I G. 1

# F I G. 2